# EUROPEAN PATENT APPLICATION

(11) **EP 4 716 013 A1**
(43) Date of publication of application: **25.03.2026**
(21) Application number: 24807541.8
(22) Date of filing: 14.05.2024
(51) Int. Cl.: H01Q 25/00, H01Q 1/38, H01Q 13/20, H01Q 1/32

(54) **ANTENNA DEVICE**

(30) Priority: 15.05.2023 KR 20230062192
(71) Applicant: LG INNOTEK CO. LTD, Gangseo-gu Seoul 07796 (KR)
(72) Inventor: KIM, Dong Jin, Seoul 07796 (KR)
(74) Representative: M. Zardi & Co S.A.
(86) International application number: PCT/KR2024/006586
(87) International publication number: WO 2024/237670

(57) **Abstract**

An antenna device according to an embodiment comprises: a substrate; and a waveguide antenna disposed adjacent to at least a part of the substrate, wherein the waveguide antenna may have a field of view (FoV) in a first direction and a FoV in a second direction different from the first direction and have at least two layers.

## Description

### [Technical Field]

The present invention relates to an antenna device, and relates to a waveguide antenna structure capable of front/rear bidirectional antenna radiation.

### [Background Art]

With the development of communication technology, devices equipped with various antennas are becoming widely deployed. These devices may transmit and receive data or signals wirelessly via antennas.

Antenna devices may be means of communication that may replace mechanically vulnerable and inconvenient wired cables between devices through wireless connections or the like. These devices are expanding to digital devices, and various forms are being researched.

Various types of antenna modules are being used in the field of electrical components, and radar systems are being developed particularly for purposes such as object detection. In line with this trend, radar modules for minimizing blind spots are required.

### [Disclosure]

### [Technical Problem]

An antenna device according to one embodiment includes a substrate and a waveguide antenna disposed close to at least a portion of the substrate, wherein the waveguide antenna has a first field of view (FoV) centered on a first direction and a second FoV centered on a second direction different from the first direction, and includes at least two layers.

The first FoV or the second FoV may have an angle in a range of 0° to 180°. The second FoV and the first FoV at least partially overlap. The first direction and the second direction may be opposite directions.

According to one embodiment, the at least two layers may include a first waveguide layer and a second waveguide layer disposed on the first waveguide layer.

According to one embodiment, the at least two layers may further include a first backed cavity layer disposed above the first waveguide layer or the second waveguide layer and a second backed cavity layer disposed below the first waveguide layer or the second waveguide layer.

According to one embodiment, the first backed cavity layer and the second backed cavity layer may be disposed in opposite directions with respect to the first waveguide layer or the second waveguide layer.

According to one embodiment, the at least two layers may further include a first radiating layer disposed above the first backed cavity layer and a second radiating layer disposed below the second backed cavity layer.

According to one embodiment, the first radiating layer and the second radiating layer may be disposed in opposite directions with respect to the first waveguide layer or the second waveguide layer.

According to one embodiment, at least a portion of the first waveguide layer or at least a portion of the second waveguide layer may extend in the first direction or the second direction.

According to one embodiment, at least a portion of the first waveguide layer or at least a portion of the second waveguide layer may extend in a direction perpendicular to the first direction or in a direction perpendicular to the second direction. The first direction or the second direction may be perpendicular to a longitudinal direction of the first waveguide layer.

According to one embodiment, the waveguide antenna may be disposed to surround at least a portion of the substrate.

According to one embodiment, the second radiating layer may be disposed close to a first side surface of a peripheral portion of the substrate.

According to one embodiment, the at least two layers may further include a third backed cavity layer disposed below the first waveguide layer or the second waveguide layer and a third radiating layer disposed below the third backed cavity layer, and the third radiating layer may be disposed close to a second side surface different from the first side surface of the peripheral portion of the substrate.

According to one embodiment, the waveguide antenna may be disposed to pass through at least a portion of the substrate.

According to one embodiment, the second radiating layer may be disposed close to one of both ends of the substrate.

According to one embodiment, the at least two layers may further include a third backed cavity layer disposed below the first waveguide layer or the second waveguide layer and a third radiating layer disposed below the third backed cavity layer, and the third radiating layer may be disposed close to the other of the both ends of the substrate.

According to one embodiment, the substrate may include a printed circuit board (PCB).

According to one embodiment, a length of at least a portion of the first radiating layer may be smaller than a length of at least a portion of the first waveguide layer or a length of at least a portion of the second waveguide layer.

According to one embodiment, a horizontal length of the first radiating layer, which corresponds to a horizontal length of an upper portion of the waveguide antenna, may be smaller than a maximum horizontal length of the first waveguide layer or a maximum horizontal length of the second waveguide layer.

According to one embodiment, a length of at least a portion of the second radiating layer may be smaller than a length of at least a portion of the first radiating layer.

According to one embodiment, when the first FoV in the first direction and the second FoV in the second direction are continuous with each other, the overall FoV may have an angle of 360° or less.

### [Description of Drawings]

FIG. 1 is a view illustrating an antenna device according to one embodiment.
FIG. 2 is a view illustrating a structure of an antenna device having a bidirectional field of view (FoV) according to one embodiment.
FIG. 3 is a view illustrating a structure of an antenna device having a bidirectional FoV according to one embodiment.
FIG. 4 is a view illustrating a structure of an antenna device according to one embodiment.
FIG. 5 is a view illustrating a structure of an antenna device according to one embodiment.
FIG. 6 is a top view of an antenna device according to one embodiment.
FIG. 7 is a bottom view of the antenna device according to one embodiment.
FIG. 8 is a cross-sectional view of the antenna device according to one embodiment.

### [Modes of the Invention]

Since the present invention may be variously modified and have several embodiments, particular embodiments thereof will be illustrated in the drawings and described. However, this is not intended to limit the present invention to the specific embodiments, and it should be understood to include all modifications, equivalents, and substitutes included in the spirit and scope of the present invention.

Although the terms including ordinal numbers such as second, first, or the like, may be used to describe various elements, the elements are not limited by the terms. Terms are only used to distinguish one element from another element. For example, without departing from the scope of the present invention, a second element can be termed a first element, and similarly, a first element may be termed a second element. The term "and/or" includes a combination of a plurality of related listed items or any of a plurality of related listed items.

It will be understood that when an element is referred to as being "coupled" or "connected" to another element, the element may be directly coupled or connected to the other element, or intervening elements may also be present. In contrast, it will be understood that when an element is referred to as being "directly coupled" or "directly connected" to another element, there are not intervening elements present.

The terms used in the present application are merely provided to describe specific embodiments, and are not intended to limit the present invention. The singular forms are intended to include the plural forms as well, unless the context clearly indicates otherwise. In the present application, it will be understood that terms "include," "have," or the like are intended to specify the presence of features, integers, steps, operations, elements, components, and/or combinations thereof stated in the specification, but do not preclude the possibility of the presence or addition of one or more other features, integers, steps, operations, elements, components, or combinations thereof in advance.

Unless otherwise defined, all terms used herein, including technical or scientific terms, have the same meaning as commonly understood by those of ordinary skill in the art to which the present invention belongs. Terms, such as those defined in commonly used dictionaries, should be interpreted as having a meaning that is consistent with their meaning in the context of the related art and will not be interpreted in an idealized or overly formal sense unless expressly so defined herein.

Hereinafter, embodiments will be described in detail with reference to the accompanying drawings, but the same or corresponding components are denoted by the same reference numerals regardless of the drawing numbers, and redundant descriptions thereof will be omitted.

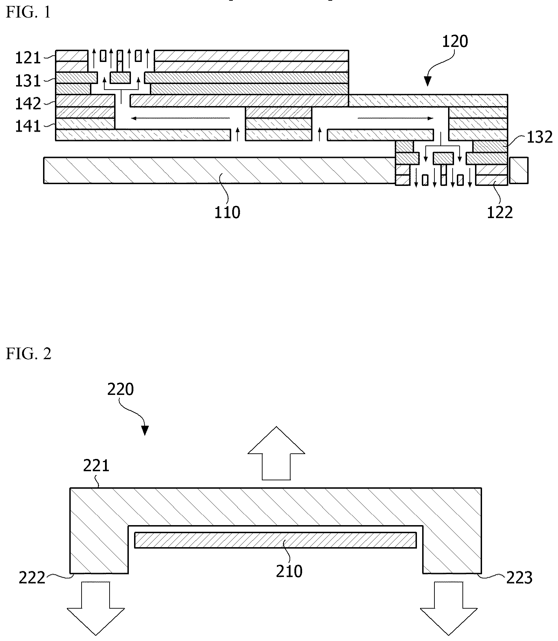

Referring to FIG. 1, an antenna device according to one embodiment may be seen.

According to one embodiment, the antenna device may include a substrate 110 and a waveguide antenna 120 disposed close to at least a portion of the substrate 110.

The antenna device may provide a waveguide antenna configuration that may significantly improve a field of view (FoV) by penetrating the substrate or using an edge portion of the substrate so that an opposite surface is also used as an antenna.

The antenna device may include at least a portion of the substrate, the antenna, an antenna module, and the like. The antenna device may include at least a portion of vehicle components. The antenna device may be mounted on at least a portion of a vehicle. The antenna device may include at least a portion of antennas used in a radar module for a vehicle.

The antenna device may provide a waveguide structure having an extended FoV in both directions.

The waveguide antenna 120 may have a first FoV in a first direction and a second FoV in a second direction different from the first direction, and may include at least two layers. Each of the at least two layers may include a plurality of layers of the same material. At least a portion of the at least two layers may be formed of different materials or the same material. In at least a portion of a cross-section of the waveguide antenna 120, each of the at least two layers may have different lengths.

The first FoV in the first direction or the second FoV in the second direction may have an angle in a range of 0° to 180° and the second FoV in the second direction may be continuous with to at least a portion of the first FoV in the first direction or may be in a direction opposite to the FoV in the first direction. When the first FoV in the first direction and the second FoV in the second direction are continuous with each other, the overall FoV may have an angle of 360° or less. When the first FoV in the first direction and the second FoV in the second direction have each an angle of 180°, are in opposite directions, and are continuous with each other, the overall FoV may have an angle of 360°.

At least a portion of the waveguide antenna 120 may have a hollow space/empty region, which provides an effect of minimizing signal transmission loss. At least a portion of the waveguide antenna 120 (e.g., a region other than at least two layers or a region between the at least two layers) may be filled with a dielectric (e.g., an insulator such as plastic), which prevents an increase in size at lower frequencies, thereby providing an advantage of reducing the size.

The waveguide antenna 120 may have a size proportional to a frequency, and in the case of a radar such as a 77 GHz ADAS radar, the cross-section of the waveguide antenna 120 may have a horizontal/vertical width or height of approximately 1 to 2 mm, and a horizontal length parallel to an upper or bottom surface may be approximately 10 to 100 mm.

According to one embodiment, the at least two layers of the waveguide antenna 120 may include a first waveguide layer 141 and a second waveguide layer 142 disposed on the first waveguide layer 141.

According to one embodiment, the at least two layers of the waveguide antenna 120 may further include a third waveguide layer (not illustrated) disposed on the second waveguide layer 142. When the third waveguide layer is further disposed, a configuration related to the second waveguide layer 142 described above or below may be applied to the third waveguide layer. For example, a component adjacent to the second waveguide layer 142 may be a component adjacent to the third waveguide layer, and a component disposed above/below the second waveguide layer 142 may be disposed above/below the third waveguide layer.

According to one embodiment, the at least two layers of the waveguide antenna 120 may include a first backed cavity layer 131 disposed above the first waveguide layer 141 or the second waveguide layer 142, and a second backed cavity layer 132 disposed below the first waveguide layer 141 or the second waveguide layer 142.

According to one embodiment, the first backed cavity layer 131 and the second backed cavity layer 132 may be disposed in opposite directions with respect to the first waveguide layer 141 or the second waveguide layer 142.

According to one embodiment, the at least two layers of the waveguide antenna 120 may include a first radiating layer 121 disposed above the first backed cavity layer 131, and a second radiating layer 122 disposed below the second backed cavity layer 132.

According to one embodiment, the first radiating layer 121 and the second radiating layer 122 may be disposed in opposite directions with respect to the first waveguide layer 141 or the second waveguide layer 142.

According to one embodiment, at least a portion of the first waveguide layer 141 or at least a portion of the second waveguide layer 142 may extend in the first direction (FoV direction) or in the second direction (another FoV direction).

According to one embodiment, at least a portion of the first waveguide layer 141 or at least a portion of the second waveguide layer 142 may extend in a direction perpendicular to the first direction or in a direction perpendicular to the second direction.

According to one embodiment, the substrate 110 may include a printed circuit board (PCB).

According to one embodiment, a length of at least a portion of the first radiating layer 121 may be smaller than a length of at least a portion of the first waveguide layer 141 or a length of at least a portion of the second waveguide layer 142.

According to one embodiment, a horizontal length of the first radiating layer 121, which corresponds to a horizontal length of an upper portion of the waveguide antenna 120, may be shorter than or equal to a maximum horizontal length of the first waveguide layer 141 or a maximum horizontal length of the second waveguide layer 142.

The maximum horizontal length of the first waveguide layer 141 or the maximum horizontal length of the second waveguide layer 142 may be 10 to 100 mm, and a maximum height of the first waveguide layer 141 or a maximum height of the second waveguide layer 142 may be approximately 1 to 2 mm.

The horizontal length of the first radiating layer 121 may be 10 to 100 mm or less, and the height of the first radiating layer 121 may be approximately 1 to 2 mm or below.

According to one embodiment, the length of at least a portion of the second radiating layer 122 may be smaller than the length of at least a portion of the first radiating layer 121.

According to one embodiment, the antenna device may significantly expand the radar FoV using at least some components of the antenna device. The antenna device has the effect of reducing the number of substrates such as the radar module, the waveguide antenna (structure) or the PCB in a system requiring multiple radars, using at least some components of the antenna device. The antenna device may be implemented as a radar module having one or more antenna portions. Accordingly, a wide FoV may be covered using a smaller number of radar modules than that of the related art.

According to one embodiment, the antenna device may include/use at least four radiating slots, a T-junction, a waveguide, a coupling feed, and the like.

Referring to FIG. 2, a structure of an antenna device having a bidirectional FoV according to one embodiment may be seen.

According to one embodiment, a waveguide antenna 220 may be disposed to surround at least a portion of a substrate 210.

The waveguide antenna 220 may utilize a peripheral portion of the substrate 210 to position its radiation aperture toward a side surface or a rear surface of the substrate 210.

According to one embodiment, a second radiating layer 222 disposed opposite to a first radiating layer 221 may be disposed close to a first side surface (e.g., a left side) of the peripheral portion of the substrate 210.

According to one embodiment, the at least two layers of the waveguide antenna 220 may further include a third backed cavity layer disposed below the first waveguide layer or the second waveguide layer, and a third radiating layer 223 disposed below the third backed cavity layer.

The third radiating layer 223 disposed opposite to the first radiating layer 221 may be disposed close to a second side surface (e.g., a right side) that is different from the first side surface of the peripheral portion of the substrate.

The waveguide antenna 220 may have a first FoV in a first direction related to the first radiating layer 221, and a second FoV in a second direction related to the second radiating layer 222 or the third radiating layer 223. The first direction may be an upper direction (upward direction) of the first radiating layer 221, and the second direction may be a lower direction (downward direction) of the second radiating layer 222 or the third radiating layer 223. Therefore, the first direction and the second direction may be opposite directions (directions opposite to each other). The first direction and the second direction may be opposite directions with respect to the substrate 210. The first direction of the first FoV in the first direction may be a propagation/radiation direction of an antenna pattern/antenna radiation pattern radiated in relation to the first radiating layer 221. The first FoV in the first direction may include a region/range/angle in which the antenna pattern/antenna radiation pattern, a signal/wave, or the like radiated in relation to the first radiating layer 221 may be received. The second direction of the second FoV in the second direction may be a propagation/radiation direction of an antenna pattern/antenna radiation pattern radiated in relation to the second radiating layer 222 or the third radiating layer 223. The second FoV in the second direction may include a region/range/angle in which an antenna pattern/antenna radiation pattern, a signal/wave, or the like radiated in relation to the second radiating layer 222 or the third radiating layer 223 may be received.

Based on a horizontal line at least parallel to a horizontal line extending from the substrate 210 or the first radiating layer 221, when the first FoV in the first direction has an angle in the range of 0° to 180°, the second FoV in the second direction, which is the opposite direction, may have an angle in the range of 180° to 360°.

When the second FoV in the second direction is continuous with at least a portion of the first FoV in the first direction, the second FoV in the second direction may start at an angle within the range from a starting angle to an ending angle of the first FoV in the first direction, and end at another angle within the range from that angle to the starting angle of the first FoV in the first direction, which is reached again (when continuous up to 360°).

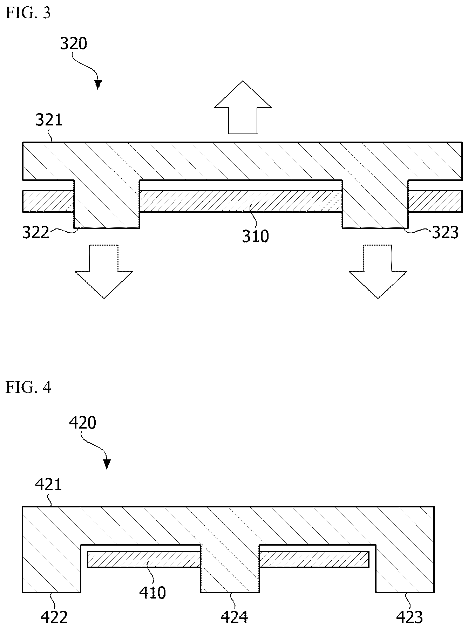

Referring to FIG. 3, a structure of an antenna device having a bidirectional FoV according to one embodiment may be seen.

According to one embodiment, a waveguide antenna 320 may be disposed to pass through at least a portion of a substrate 310. The waveguide antenna 320 may be disposed to pass through a portion of the substrate 310 such as a PCB by penetrating the portion.

According to one embodiment, a second radiating layer 322 disposed opposite to a first radiating layer 321 may be disposed close to one (e.g., a left end) of both ends of the substrate 310.

According to one embodiment, the at least two layers may further include a third backed cavity layer disposed below the first waveguide layer or the second waveguide layer, and a third radiating layer 323 disposed below the third backed cavity layer.

The third radiating layer 323 disposed opposite to the first radiating layer 321 may be disposed close to the other (e.g., a right end) of the both ends of the substrate 310.

Referring to FIG. 4, a structure of an antenna device according to one embodiment may be seen.

According to one embodiment, a waveguide antenna 420 may be disposed to surround at least a portion of a substrate 410.

According to one embodiment, a second radiating layer 422 disposed opposite to a first radiating layer 421 may be disposed close to a first side surface (e.g., a left side) of the peripheral portion of the substrate 410.

According to one embodiment, the at least two layers of the waveguide antenna 420 may further include a third backed cavity layer disposed below the first waveguide layer or the second waveguide layer, and a third radiating layer 423 disposed below the third backed cavity layer.

The third radiating layer 423 disposed opposite to the first radiating layer 421 may be disposed close to a second side surface (e.g., a right side) that is different from the first side surface of the peripheral portion of the substrate.

According to one embodiment, the at least two layers of the waveguide antenna 420 may further include a fourth backed cavity layer disposed below the first waveguide layer or the second waveguide layer, and a fourth radiating layer 424 disposed below the fourth backed cavity layer.

The fourth radiating layer 424 disposed opposite to the first radiating layer 421 may be disposed close to a region between a first side surface and a second side surface of the peripheral portion of the substrate. The fourth radiating layer 424 may be disposed close to a center or middle of the substrate, or the fourth radiating layer 424 may be disposed to pass through the center or middle of the substrate. The fourth radiating layer 424 may be displaced at the center or middle of the substrate.

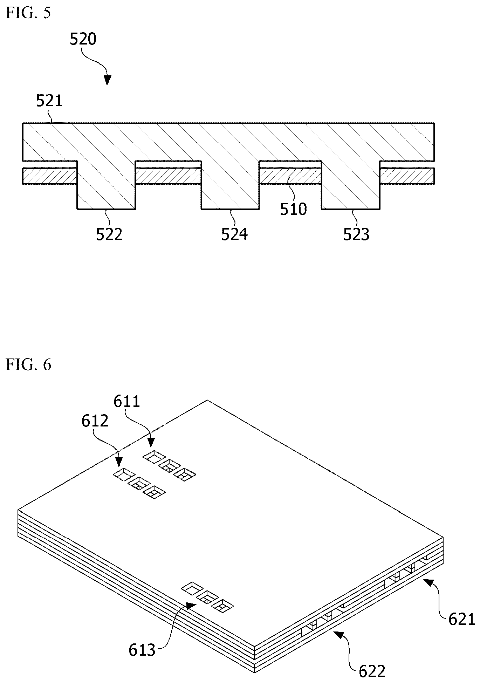

Referring to FIG. 5, a structure of an antenna device according to one embodiment may be seen.

According to one embodiment, a waveguide antenna 520 may be disposed to pass through at least a portion of a substrate 510.

According to one embodiment, a second radiating layer 522 disposed opposite to a first radiating layer 521 may be disposed close to one (e.g., a left end) of both ends of the substrate 510.

According to one embodiment, the at least two layers may further include a third backed cavity layer disposed below the first waveguide layer or the second waveguide layer, and a third radiating layer 523 disposed below the third backed cavity layer.

The third radiating layer 523 disposed opposite to the first radiating layer 521 may be disposed close to the other (e.g., a right end) of the both ends of the substrate 510.

According to one embodiment, the at least two layers of the waveguide antenna 520 may further include a fourth backed cavity layer disposed below the first waveguide layer or the second waveguide layer, and a fourth radiating layer 524 disposed below the fourth backed cavity layer.

The fourth radiating layer 524 disposed opposite to the first radiating layer 521 may be disposed close to at least a portion of the substrate between the second radiating layer 522 and the third radiating layer 523. The fourth radiating layer 524 may be disposed close to a center or middle of the substrate, or the fourth radiating layer 524 may be disposed to pass through the center or middle of the substrate. The fourth radiating layer 524 may be displaced at the center or middle of the substrate.

FIG. 6 is a top view of an antenna device according to one embodiment.

The antenna device may be disposed in multiple directions, each of which is a rotated direction obtained when the antenna device itself is rotated at once, and the directions described herein may be changed by various applied embodiments. For example, up-down disposition may be changed to front-back or left-right disposition.

The antenna device may include a substrate and a waveguide antenna disposed close to at least a portion of the substrate.

The waveguide antenna may include a first upper surface antenna portion 611, a second upper surface antenna portion 612, and a third upper surface antenna portion 613. When the antenna device rotates to change the up-down disposition to the front-back disposition, the first upper surface antenna portion 611, the second upper surface antenna portion 612, and the third upper surface antenna portion 613 may become a first front surface antenna portion, a second front surface antenna portion, and a third front surface antenna portion, respectively.

Each antenna portion of the waveguide antenna may include at least a portion of the antenna and may refer to a portion that performs the operation/working of the antenna.

The waveguide antenna may further include a first side surface antenna portion 621 and a second side surface antenna portion 622.

The waveguide antenna may have a first FoV centered on a first direction using at least one of the first upper surface antenna portion 611, the second upper surface antenna portion 612, and the third upper surface antenna portion 613.

The first direction of the first FoV in the first direction is an upward direction with respect to an upper surface of the antenna device or the waveguide antenna. The first direction may be perpendicular to the upper surface of the antenna device or the waveguide antenna.

The waveguide antenna may have a second FoV centered on the second direction using at least one of a first side surface antenna portion 621 and a second side surface antenna portion 622.

The second direction may be a different direction from the first direction. The second direction of the second FoV in the second direction is a lateral direction (e.g., right side) with respect to a side surface of the antenna device or the waveguide antenna. The second direction may be perpendicular to the side surface of the antenna device or the waveguide antenna.

The waveguide antenna may include at least two layers. The first FoV or the second FoV may have an angle in the range of 0° to 180°. The second FoV and the first FoV may at least partially overlap. The first direction or the second direction may be perpendicular to at least one longitudinal direction of the first waveguide layer.

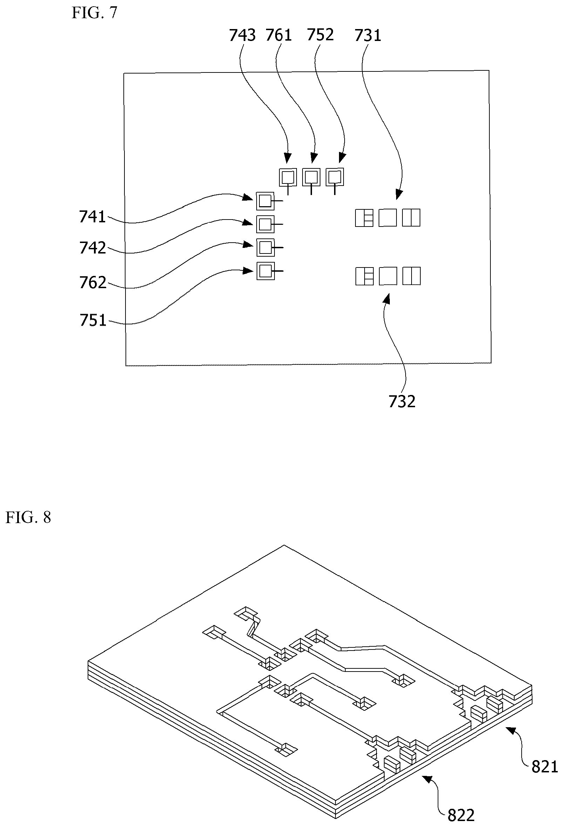

FIG. 7 is a bottom view of an antenna device according to one embodiment.

A waveguide antenna of the antenna device may include a first bottom surface antenna portion 731 and a second bottom surface antenna portion 732. When the antenna device rotates to change up-down disposition to front-back disposition, the first bottom surface antenna portion 731 and the second bottom surface antenna portion 732 may become a first rear surface antenna portion and a second rear surface antenna portion, respectively.

The waveguide antenna may have a second FoV centered on the second direction using at least one of the first bottom surface antenna portion 731 and the second bottom surface antenna portion 732.

The second direction may be a direction different from the first direction. When the waveguide antenna has the second FoV centered on the second direction using at least one of the first bottom surface antenna portion 731 and the second bottom surface antenna portion 732, the second direction of the second FoV in the second direction is a downward direction with respect to the bottom surface of the antenna device or the waveguide antenna. The second direction may be perpendicular to the bottom surface of the antenna device or the waveguide antenna.

The waveguide antenna may have at least two layers. The first FoV or the second FoV may have an angle in the range of 0° to 180°. The first direction and the second direction may be opposite directions. The first direction or the second direction may be perpendicular to at least one longitudinal direction of the first waveguide layer.

The antenna device may further include an antenna feed portion corresponding to each antenna portion. The antenna feed portion may include at least a portion of a PCB antenna feed.

The antenna device may include a first upper surface antenna feed portion 741, a second upper surface antenna feed portion 742, a third upper surface antenna feed portion 743, a first side surface antenna feed portion 751, a second side surface antenna feed portion 752, a first bottom surface antenna feed portion 761, and a second bottom surface antenna feed portion 762.

Each of the first upper surface antenna feed portion 741, the second upper surface antenna feed portion 742, the third upper surface antenna feed portion 743, the first side surface antenna feed portion 751, the second side surface antenna feed portion 752, the first bottom surface antenna feed portion 761, and the second bottom surface antenna feed portion 762 may be disposed on the bottom surface of the antenna device or the waveguide antenna, or may be disposed close to the bottom surface of the antenna device or the waveguide antenna.

The first upper surface antenna feed portion 741, the second upper surface antenna feed portion 742, the third upper surface antenna feed portion 743, the first side surface antenna feed portion 751, the second side surface antenna feed portion 752, the first bottom surface antenna feed portion 761, and the second bottom surface antenna feed portion 762 may be disposed in a specific arrangement form. The specific arrangement may include a first arrangement and a second arrangement, and the first arrangement and the second arrangement may be vertically disposed.

The first arrangement may include a linear arrangement in the order of the first upper surface antenna feed portion 741, the second upper surface antenna feed portion 742, the second bottom surface antenna feed portion 762, and the first side surface antenna feed portion 751. The second arrangement may include a linear arrangement in the order of the third upper surface antenna feed portion 743, the first bottom surface antenna feed portion 761, and the second side surface antenna feed portion 752.

When the antenna device rotates to change up-down disposition to front-rear disposition, the first upper surface antenna feed portion 741, the second upper surface antenna feed portion 742, and the third upper surface antenna feed portion 743 may become a first front surface antenna feed portion, a second front surface antenna feed portion, and a third front surface antenna feed portion, respectively, and the first bottom surface antenna feed portion 761 and the second bottom surface antenna feed portion 762 may become a first rear surface antenna feed portion and a second rear surface antenna feed portion, respectively.

FIG. 8 is a cross-sectional view of an antenna device according to one embodiment.

Looking at a structure of one cross-section of an antenna device or a waveguide antenna, an internal structure of a first side surface antenna portion 821 and a second side surface antenna portion 822 may be seen.

The first side surface antenna portion 821 and the second side surface antenna portion 822 may include a plurality of layers. The plurality of layers may include at least a portion of at least two layers described above.

While the present invention has been described with reference to the embodiments, but these are only exemplary and do not intend to limit the present invention, and those skilled in the art to which the present invention pertains will appreciate that various modifications, variations, and alterations that are not illustrated above could be made without departing from the essential characteristics of the present embodiments. For example, the components specifically shown in the embodiments may be modified. It should be construed that differences associated with such modifications and alternations fall within the scope of the present invention defined by the accompanying claims.

## Claims

1. An antenna device comprising:
a substrate; and
a waveguide antenna disposed close to at least a portion of the substrate,
wherein the waveguide antenna has a first field of view (FoV) centered on a first direction and a second FoV centered on a second direction different from the first direction,
the waveguide antenna includes at least two layers,
the first FoV or the second FoV has an angle in a range of 0° to 180°, and
the second FoV and the first FoV at least partially overlap or the first direction and the second direction are opposite directions.

2. The antenna device of claim 1, wherein the at least two layers include:
a first waveguide layer; and
a second waveguide layer disposed on the first waveguide layer.

3. The antenna device of claim 2, wherein the at least two layers further includes:
a first backed cavity layer disposed above the first waveguide layer or the second waveguide layer; and
a second backed cavity layer disposed below the first waveguide layer or the second waveguide layer.

4. The antenna device of claim 3, wherein the first backed cavity layer and the second backed cavity layer are disposed in opposite directions with respect to the first waveguide layer or the second waveguide layer.

5. The antenna device of claim 3, wherein the at least two layers further include:
a first radiating layer disposed above the first backed cavity layer; and
a second radiating layer disposed below the second backed cavity layer.

6. The antenna device of claim 5, wherein the first radiating layer and the second radiating layer are disposed in opposite directions with respect to the first waveguide layer or the second waveguide layer.

7. The antenna device of claim 5, wherein the second radiating layer is disposed close to a first side surface of a peripheral portion of the substrate.

8. The antenna device of claim 7, wherein the at least two layers further include:
a third backed cavity layer disposed below the first waveguide layer or the second waveguide layer; and
a third radiating layer disposed below the third backed cavity layer, and
the third radiating layer is disposed close to a second side surface different from the first side surface of the peripheral portion of the substrate.

9. The antenna device of claim 5, wherein the second radiating layer is disposed close to one of both ends of the substrate.

10. The antenna device of claim 9, wherein the at least two layers further include:
a third backed cavity layer disposed below the first waveguide layer or the second waveguide layer; and
a third radiating layer disposed below the third backed cavity layer, and
the third radiating layer is disposed close to the other of the both ends of the substrate.
